# EUROPEAN PATENT SPECIFICATION

(11) **EP 2 182 549 B1**
(45) Date of publication and mention of the grant of the patent: **25.02.2015**
(21) Application number: 08168174.4
(22) Date of filing: 03.11.2008
(51) Int. Cl.: H01L 21/683, B25B 11/00

(54) **Mobile table and lamination system comprising such table**
Fahrtisch und Laminierungssystem, das einen solchen Tisch umfasst
Table mobile et système de stratification comportant une telle table

(43) Date of publication of application: 05.05.2010
(73) Proprietor: Eurotron B.V., 2971 VL Bleskensgraaf (NL)
(72) Inventor: Bakker, Jan, 2971 VL Bleskensgraaf (NL); Verschoor, Abraham Jan, 3366 BG Wijngaarden (NL); den Hartigh, Simon, 2969 BG Oud Alblas (NL)
(74) Representative: Nollen, Maarten Dirk-Johan

(56) References cited:
- WO-A-2008/119355
- WO-A-2009/001889
- GB-A- 2 435 843
- JP-A- 11 026 553
- JP-A- 2005 059 173
- JP-A- 2005 288 591
- US-A- 3 042 356
- US-A- 3 122 085
- US-A- 3 431 009
- US-A- 3 466 079
- US-A- 3 797 797
- US-A- 5 775 395
- US-A1- 2003 141 673
- US-B1- 6 615 150

## Description

The invention is related to a mobile table for preparing a planar product such as a stack of sheets, a laminate and the like, said table comprising a frame, a support panel carried by the frame for supporting a planar product, as well as vacuum means comprising at least one vacuum generator and at least one energy source for driving said vacuum generator, said vacuum means cooperating with the support panel for creating an underpressure between the support panel and a product supported thereon.

Such mobile tables are known. The planar product laminates which can be produced by means of such mobile table include amongst others solar cell assemblies such as crystalline silicon photovoltaic modules. Such modules comprises several layers, including a back sheet foil comprising an electrical pattern for interconnection of solar cells, a conductive paste deposition on the conductive tracks of the foil and a preprocessed sheet of EVA. Also, a cover glass plate is included in the laminate.

However, other solar cell assemblies which comprise traditional cells interconnected through strings lying on top of the cells can be treated by said tables as well.

Having regard to the fact that the several layers mentioned before must be placed according to a precise position on top of each other, in the present example the back sheet foil should be placed accurately on the support panel and also should be held accurately in said position. This is achieved by applying a partial vacuum between such foil and the support panel. Usually, to that end the support panel is connected to vacuum source which is present at the manufacturing site, for instance through a vacuum line which extends between a wall mounted connection and the support table.

Although such procedure is suitable for some applications, problems arise in case the mobile table has to be displaced over larger distances. In that case the vacuum line connection forms an obstacle which prevents the mobile table from being handled and displaced as desired. For instance, in the case of solar cell production, the mobile table carrying the laminate has to be transported to a subsequent production station, which subsequent station cannot be at a larger distance than allowed by the length of the vacuum line. Usually, several mobile tables are used in the manufacturing process described before.

JP2005-059173A1 discloses a portable suction device comprising a vacuum generator, and a change over apparatus in a chuck table. In use, the suction device sucks or releases a work piece from the chuck table using air supplied from an air supply port by operation of a knob of the change-over apparatus.

WO2008/119355 discloses a vacuum plate for releasably fastening items to be worked on, to a surface of the plate. The plate comprises a box structure having a bottom plate, four sides and a top plate, wherein the top plate is provided with at least one aperture, and wherein the volume enclosed by the box structure comprises for each aperture a separate air duct passing under the aperture. All air ducts are connected to a source of pressurised air. A venturi is arranged in each air duct upstream in relation to the aperture and an air outlet is provided downstream from said aperture. The aperture is in communication with the air duct between the venturi and the outlet.

The object of the invention is therefore to provide a mobile table which can be handled in a more flexible way, and which is not limited with respect to its displacements while maintaining a vacuum. Said object is achieved as claimed in claim 1.

According to the invention, the mobile table is self-sufficient in the sense that it is able to generate and/or sustain a partial vacuum of the desired level between the support panel and the laminar product carried thereby. The requirement of maintaining the vacuum in a self-sufficient way needs only to be fulfilled during a limited amount of time, that is the amount of time during which the mobile table is remote from a stationary vacuum source.

The energy source comprises at least one overpressure tank and the vacuum generator comprises at least one venturi device, the pressure side of said venture device being connected to said overpressure tank and the suction side of said venturi device being connected to an aperture in the support panel. The advantage of an overpressure tank is that it may contain a gas under a high pressure, such that a large amount of energy can be stored in the overpressure tank. These tanks themselves can be of a simple construction, and may for instance be formed from thick-walled pipes which are closed at the ends, for instance by means of welded or screwed end stubs.

With the aim of providing a reliable vacuum over the full extent of the mobile table and the product carried thereby, several generators may be provided in combination with a support panel that comprises several support zones. In this embodiment, each support zone is connected to a respective vacuum generator. Additionally, sensors means may be mounted at a bottom side of the support panel for sensing the presence and/or absence of a product on the supporting panel. Also, control means for controlling the application of a vacuum between the support panel and the product on said panel may be mounted at a bottom side of the support panel. An example of a device which may be applied for sensing and controlling the vacuum generator is represented by a vacuum-controlled valve.

The support panel can be carried out in different ways; according to a preferred embodiment the support panel comprises at least one recessed area which is enclosed by a continuous raised circumference, an aperture being provided in the recessed area, said aperture being connected to the vacuum means. The recessed area provides ample space for applying a vacuum to a large area of the product carried by the support panel. With the aim of supporting said product evenly over the full surface of the support panel, supports may be provided which are raised with respect to the recessed area and which are positioned within the raised circumference. A very firm and reliable support of the product is obtained in case the top side of the support panel is covered by a perforated sheet.
With the aim of charging the tanks, each overpressure tank comprises port means for connection to an external overpressure source. Such external overpressure source is for instance a stationary compression machine, provided with connectors onto which the port means of the overpressure tanks can be connected for carrying out intermediate chargings.

The invention is furthermore related to a lamination system comprising at least one mobile table as described before and a stationary power source connectable to the energy source of the table for supplying power to said energy source. Preferably, the external energy source comprises compressed gas such as compressed air.

The invention will now be described with reference to an embodiment shown in the drawings.
Figure 1 shows the vertical section through a mobile table according to the invention.
Figure 2 shows a top view in perspective of the support panel of the mobile table with the top sheet removed.
Figure 3 shows the bottom view in perspective of the support panel of the mobile table.
Figure 4 shows a venturi device vacuum generator.
Figure 5 shows a complete lamination system including a stationary power source.

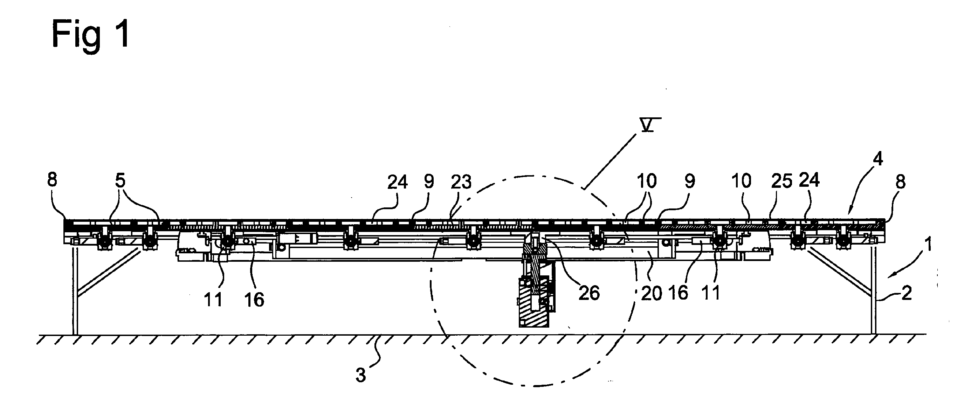

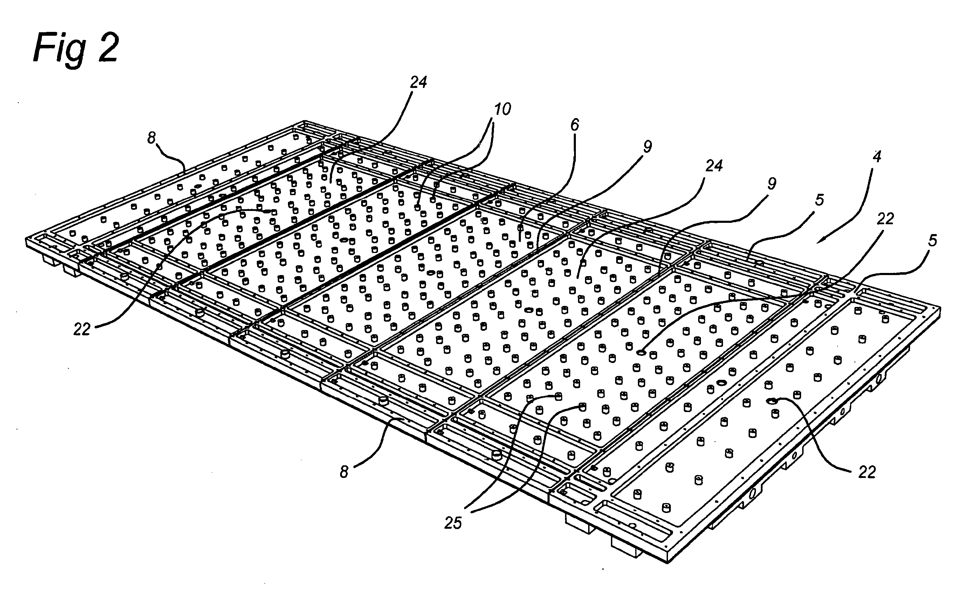

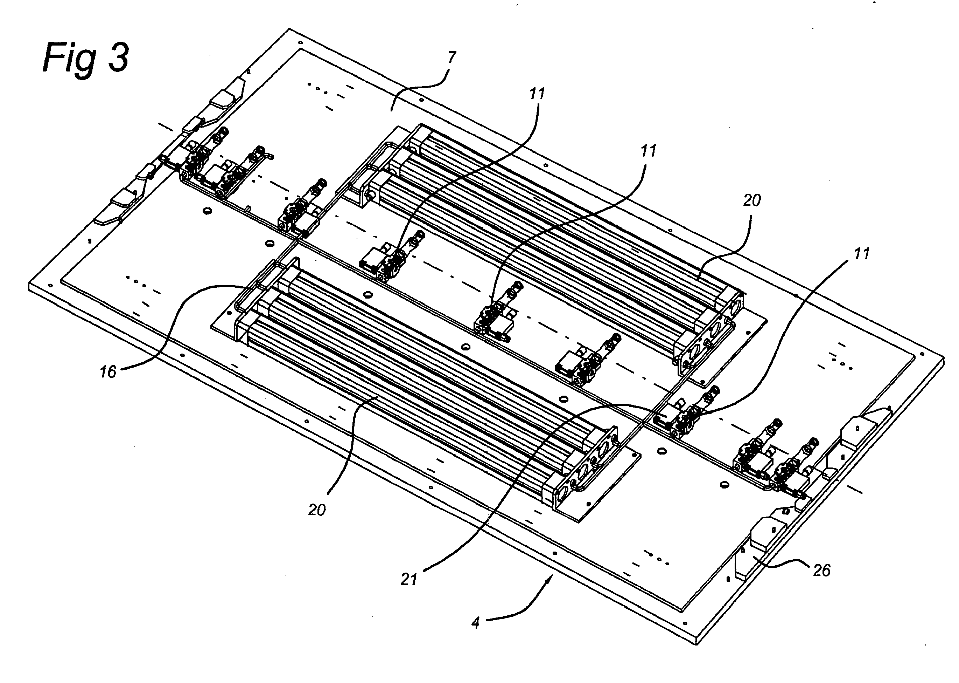

The mobile table shown in figure 1 comprises a frame 1 which in general consists of legs 2. The frame 1 rests on a transport system 3 for displacing the table. Said frame 1 carries a support panel which in general has been indicated by reference numeral 4. In the embodiment shown, the support panel 4 consists of several interconnected sections 5. However, it is also possible that the support panel 4 is carried out as a single unity. In the embodiment shown, the support panel has a top side 6 (see figure 2) and a bottom side 7 (see figure 3). The top side 6 of the support panel 4 is provided with a circumferential raised edge 8. The several sections 5 do have raised edges 9 as well.

Within the areas defined between the raised edges 8, 9, supports stubs 25 had been applied. As is clear from figure 1, the height of these support stubs 25 is generally equal to the height of the raised edges 8, 9. Together with the raised edges 8, 9, these the support stubs 25 support the perforated sheet 10 as shown in figure 1. For clarity's sake, this perforated sheet has not been shown in figure 2.

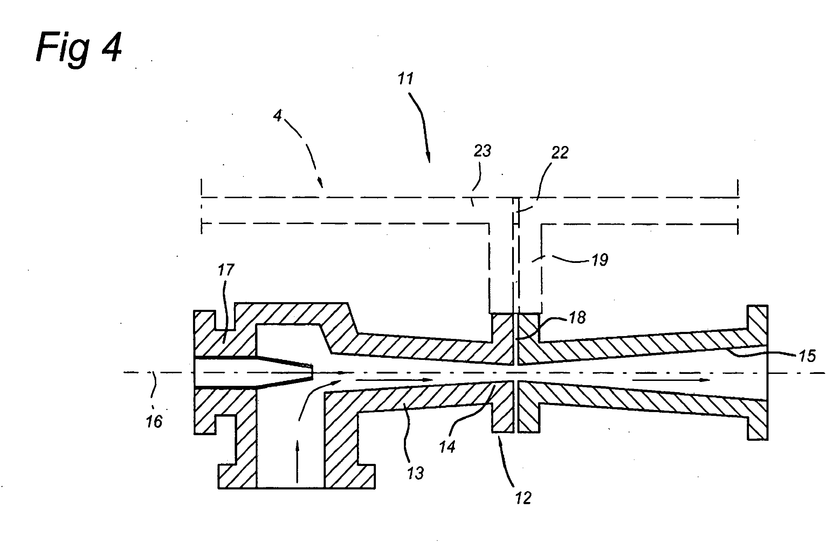

In the embodiment shown, each section 5 has been provided with its own the vacuum generator 11. Such vacuum generator 11 is shown in figure 4, and comprises the venturi device 12. Said venturi device 12 consists, in a known way of a tube 13 having an internal constriction 14 in its passageway 15. By means of a pressure hose 16, compressed air is supplied to the pressure side 17 of the tube 13. As a result of the flow through the passageway 15, an underpressure or partial vacuum is generated at the constriction 14, which underpressure also reigns in the venturi channel 18 which emanates in the constriction 14. Through the connector 19 and the opening 22 in the bottom 23 of the support panel, this underpressure is communicated with the recessed area or space 24 between said bottom 23 and the perforated sheet 10.

The pressure hose 16 is connected to the pressure tanks 20 which are mounted at the bottom side 7 of the support panel 4. These pressure tanks 20 can be filled with compressed gas by means of the port 26, which can be connected to a stationary, external pressurized gas source. By means of the control devices 21, pressurized gas from these pressure tanks 20 is supplied to the vacuum generators 11 in such a way as to maintain the desired or partial vacuum between the support panel 4 and a laminate product (not shown) supported on the perforated sheet 10 thereof.

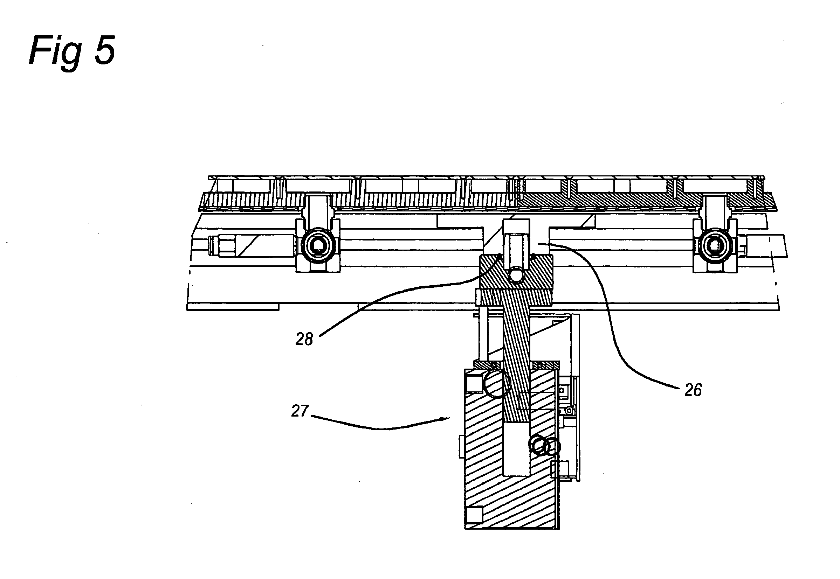

Figure 5 shows a complete lamination system, which consists of the mobile table described before as well as a stationary power source. In the embodiment shown, the stationary power source comprises an air cylinder 27. By extending the air cylinder 27, a fill nozzle 28 can be connected to the port 26 carried by the mobile table. After connection of the stationary power source to the mobile table, the pressure tanks 20 can be filled with pressurized gas. Subsequently, the fill nozzle 28 is detached from the fill port 26 by reconnecting the air cylinder 27, and a non-return valve closes the fill port.

### List of reference numerals

- 1. :: Frame
- 2. :: Leg
- 3. :: Transport system
- 4. :: Support panel
- 5. :: Section
- 6. :: Top side support panel
- 7. :: Bottom side support panel
- 8. :: Circumferential raised edge
- 9. :: Intermediate raised edge
- 10. :: Perforated sheet
- 11. :: Vacuum generator
- 12. :: Venturi device
- 13. :: Tube venturi device
- 14. :: Constriction in tube
- 15. :: Passageway of tube
- 16. :: Pressure hose
- 17. :: Pressure side of venturi device
- 18. :: Lateral venturi channel (suction side)
- 19. :: Connection pipe
- 20. :: Pressure tank
- 21. :: Control device
- 22. :: Opening in bottom support panel
- 23. :: Bottom support panel
- 24. :: Recessed area support panel
- 25. :: Support stub
- 26. :: Port means pressure tank
- 27. :: Air cylinder
- 28. :: Fill port

## Claims

1. Mobile table for preparing a planar product such as a stack of sheets, a laminate and the like, said table comprising a frame (1), a support panel (4) carried by the frame for supporting a planar product, as well as vacuum means comprising at least one vacuum generator (11) and at least one energy source (20) for driving said vacuum generator, said vacuum means cooperating with the support panel (4) for creating an underpressure between the support panel and a product supported thereon,
**Characterized in that**
- the at least one energy source comprises an overpressure tank (20) and the at least one vacuum generator (11) comprises a venturi device (12) provided with a pressure side (17) and a suction side (18), the pressure side (17) of said venturi device being connected to said overpressure tank (20) and the suction side (18) of said venturi device being connected to an aperture (22) in the support panel (4), and
- the at least one vacuum generator and the at least one energy source of the vacuum means (11, 20) are mounted at a bottom side of the support panel (4) so as to maintain said underpressure during a limited amount of time during which the mobile table is remote from a stationary power source for supplying power to the at least one energy source.

2. Mobile table according to claim 1, wherein several vacuum generators (11) are provided and the support panel (4) comprises several support zones (9) each support zone (9) being connected to a respective vacuum generator (11).

3. Mobile table according to any of the preceding claims, wherein sensor means are mounted at a bottom side of the support panel for sensing the presence and/or absence of a product on the support panel (4) and/or for sensing the vacuum magnitude of said underpressure.

4. Mobile table according to any of the preceding claims, wherein control means (21) are carried by the frame (1) for controlling the application of the underpressure between the support panel (4) and the product on said support panel (4).

5. Mobile table according to claims 3 and 4, wherein the control means (21) comprising a vacuum-controlled valve.

6. Mobile table according to any of the preceding claims, wherein the support panel (4) comprises at least one recessed area (24) which is enclosed by a continuous raised circumference (8,9), an aperture (22) being provided in the recessed area (24), said aperture (22) being connected to the vacuum means (11, 20).

7. Mobile table according to claim 6, wherein supports (25) are provided which are raised with respect to the recessed area (24) and which are positioned within the raised circumference (8, 9).

8. Mobile table according to any of the preceding claims, wherein the top side of the support panel (4) is covered by a perforated sheet.

9. Mobile table according to claim 1, wherein each overpressure tank (20) comprises port means (26) for connection to an external overpressure filling source.

10. Lamination system comprising at least one mobile table according to any of the preceding claims and a stationary power source (27) connectable to the energy source of the vacuum means of the mobile table for providing power to said energy source.

11. Lamination system as claimed in claim 10, wherein the stationary power source (27) comprises compressed gas such as compressed air.

12. Use of the mobile table as claimed in any of the claims 1-9 for transportation of a planar product to a subsequent production station, wherein an underpressure created between the support panel of the table and the product carried thereby is maintained during a limited time during which the mobile table is remote from a stationary power source.

13. Use as claimed in Claim 12, wherein the planar product is a solar cell assembly.

## Patentansprüche

1. Mobiler Tisch zur Herstellung eines ebenen Erzeugnisses wie eines Stapels von Platten, eines Laminats und dergleichen, wobei der Tisch einen Rahmen (1), ein Stützpaneel (4), das vom Rahmen getragen ist zum Stützen des ebenen Erzeugnisses, sowie Vakuummittel aufweist, die mindestens einen Vakuumerzeuger (11) und mindestens eine Energiequelle (20) zum Antrieb des Vakuumerzeugers aufweisen, wobei die Vakuummittel mit dem Stützpaneel (4) zusammenwirken, um einen Unterdruck zwischen der Stützplatte und dem daran abgestützten Erzeugnis zu erzeugen,
**dadurch gekennzeichnet, dass**
- die mindestens eine Energiequelle einen Überdruckbehälter (20) aufweist und der mindestens eine Vakuumerzeuger (11) ein Venturi-Gerät (12) aufweist, das mit einer Druckseite (17) und einer Saugseite (18) versehen ist, wobei die Druckseite (17) des Venturi-Geräts mit dem Überdruckbehälter (20) verbunden ist und die Saugseite (18) des Venturi-Geräts mit einer Öffnung (22) in dem Stützpaneel (4) verbunden ist, und
- der mindestens eine Vakuumerzeuger und die mindestens eine Energiequelle der Vakuummittel (11, 20) an der Unterseite des Stützpaneels (4) angebracht sind, um den Unterdruck während eines begrenzten Zeitraums zu erhalten, in dem der mobile Tisch von einer stationären Energiequelle zum Zuführen von Energie an die wenigstens eine Energiequelle entfernt gelegen ist.

2. Mobiler Tisch gemäß Anspruch 1, wobei mehrere Vakuumerzeuger (11) bereitgestellt sind und das Stützpaneel (4) mehrere Stützbereiche (9) aufweist, wobei jeder Stützbereich (9) mit einem jeweiligen Vakuumerzeuger (11) verbunden ist.

3. Mobiler Tisch gemäß irgendeinem der vorangegangenen Ansprüche, wobei Sensormittel an einer Unterseite des Stützpaneels zum Erfassen des Vorliegens und/oder Fehlens eines Erzeugnisses auf dem Stützpaneel (4) und/oder zum Erfassen der Vakuumstärke des besagten Unterdrucks angebracht sind.

4. Mobiler Tisch gemäß irgendeinem der vorangegangenen Ansprüche, wobei Steuermittel (21) zum Steuern der Aufbringung des Unterdrucks zwischen dem Stützpaneel (4) und dem Erzeugnis auf dem Stützpaneel (4) vom Rahmen (1) getragen werden.

5. Mobiler Tisch gemäß Ansprüchen 3 und 4, wobei die Steuermittel (21) ein vakuumgesteuertes Ventil aufweisen.

6. Mobiler Tisch gemäß irgendeinem der vorangegangenen Ansprüche, wobei das Stützpaneel (4) mindestens einen ausgesparten Bereich (24) aufweist, der von einem kontinuierlichen, erhöhten Umfang (8, 9) umschlossen ist, wobei eine Öffnung (22) in dem ausgesparten Bereich (24) liegt, wobei die Öffnung (22) mit den Vakuummitteln (11, 20) verbunden ist.

7. Mobiler Tisch gemäß Anspruch 6, wobei Stützen (25) bereitgestellt sind, die bezüglich des ausgesparten Bereichs (24) erhöht sind und die sich innerhalb des erhöhten Umfangs (8, 9) befinden.

8. Mobiler Tisch gemäß irgendeinem der vorangegangenen Ansprüche, wobei die Oberseite des Stützpaneels (4) mit einer perforierten Platte bedeckt ist.

9. Mobiler Tisch gemäß Anspruch 1, wobei jeder Überdruckbehälter (20) Anschlussmittel (26) zur Verbindung mit einer externen Überdruckbefüllungsquelle aufweist.

10. Laminierungssystem, aufweisend mindestens einen mobilen Tisch gemäß irgendeinem der vorangegangenen Ansprüche und eine stationäre Energiequelle (27), welche an die Energiequelle der Vakuummittel des mobilen Tischs zur Energieversorgung besagter Energiequelle anschließbar ist.

11. Laminierungssystem wie in Anspruch 10 beansprucht, wobei die stationäre Energiequelle (27) ein komprimiertes Gas, wie z.B. Druckluft, aufweist.

12. Verwendung des mobilen Tischs wie in irgendeinem der Ansprüche 1-9 beansprucht zur Beförderung eines ebenen Erzeugnisses zu einer nachfolgenden Produktionsstelle, wofür ein Unterdruck, der zwischen dem Stützpaneel des mobilen Tischs und dem davon getragenen Erzeugnis erzeugt wird, während eines begrenzten Zeitraumes aufrechterhalten wird, während dessen der mobile Tisch von einer stationären Energiequelle entfernt gelegen ist.

13. Verwendung wie in Anspruch 12 beansprucht, wobei das ebene Erzeugnis eine Solarzellengruppe ist.

## Revendications

1. Table mobile destinée à préparer un produit plan tel qu'un empilement de feuilles, un stratifié et un analogue, ladite table comprenant un châssis (1), un panneau de support (4) maintenu par le châssis afin de supporter un produit plan, de même qu'un moyen d'aspiration comprenant au moins un générateur de vide (11) et au moins une source d'alimentation (20) afin d'entraîner ledit générateur de vide, ledit moyen d'aspiration coopérant avec le panneau de support (4) afin de créer une dépression entre le panneau de support et un produit supporté sur celui-ci,
**caractérisée en ce que**
- la ou les sources d'alimentation comprend un réservoir en surpression (20) et le ou les générateurs de vide (11) comprend un dispositif formant venturi (12) présentant un côté de pression (17) et un côté d'aspiration (18), le côté de pression (17) dudit dispositif formant venturi étant raccordé audit réservoir en surpression (20) et le côté aspiration (18) dudit dispositif formant venturi étant raccordé à une ouverture (22) sur le panneau de support (4), et
- le ou les générateurs de vide et la ou les sources d'alimentation du moyen d'aspiration (11, 20) sont montés sur un côté inférieur du panneau de support (4) de manière à maintenir ladite dépression pendant une durée limitée au cours de laquelle la table mobile est éloignée d'une source d'alimentation fixe pour fournir de l'énergie à la ou aux sources d'alimentation.

2. Table mobile selon la revendication 1, dans laquelle plusieurs générateurs de vide (11) sont agencés et le panneau de support (4) comprend plusieurs zones de support (9), chaque zone de support (9) étant raccordée à un générateur de vide (11) respectif.

3. Table mobile selon l'une quelconque des revendications précédentes, dans laquelle des moyens de détection sont montés sur un côté inférieur du panneau de support de manière à détecter la présence et/ou l'absence d'un produit sur le panneau de support (4) et/ou de détecter le niveau de vide de ladite dépression.

4. Table mobile selon l'une quelconque des revendications précédentes, dans laquelle des moyens de commande (21) sont supportés par le châssis (1) pour commander l'application de la dépression entre le panneau de support (4) et le produit sur ledit panneau de support (4).

5. Table mobile selon les revendications 3 et 4, dans laquelle les moyens de commande (21) comprennent une vanne de commande d'aspiration.

6. Table mobile selon l'une quelconque des revendications précédentes, dans laquelle le panneau de support (4) comprend au moins une zone concave (24) qui est délimitée par une circonférence surélevée continue (8, 9), une ouverture (22) étant agencée sur la zone concave (24), ladite ouverture (22) étant raccordée aux moyens de mise sous vide (11, 20).

7. Table mobile selon la revendication 6, dans laquelle des supports (25) sont prévus qui sont surélevés par rapport à la zone concave (24) et qui sont disposés à l'intérieur de la circonférence surélevée (8, 9).

8. Table mobile selon l'une quelconque des revendications précédentes, dans laquelle le côté supérieur du panneau de support (4) est recouvert d'une tôle perforée.

9. Table mobile selon la revendication 1, dans laquelle chaque réservoir en surpression (20) comprend un moyen formant orifice (26) pour raccordement à une source externe de remplissage en surpression.

10. Système de laminage comprenant au moins une table mobile selon l'une quelconque des revendications précédentes et une source d'alimentation fixe (27) pouvant être raccordée à la source d'alimentation du moyen de mise sous vide de la table mobile afin de fournir de l'énergie à ladite source d'alimentation.

11. Système de laminage selon la revendication 10, dans laquelle la source d'alimentation fixe (27) comprend un gaz comprimé tel l'air comprimé.

12. Utilisation de la table mobile selon l'une quelconque des revendications 1 à 9, afin d'assurer le transport d'un produit plan vers une station de production complémentaire, où une dépression créée entre le panneau de support de la table et le produit ainsi transporté est maintenue sur une durée limitée pendant laquelle la table mobile est éloignée d'une source d'alimentation fixe.

13. Utilisation selon la revendication 12, dans laquelle le produit plan est un ensemble de cellules photovoltaïques.
